# FASCICULE DE BREVET EUROPEEN

(11) **EP 1 559 138 B1**
(45) Date de publication et mention de la délivrance du brevet: **21.04.2010**
(21) Numéro de dépôt: 03767871.1
(22) Date de dépôt: 31.10.2003
(51) Int. Cl.: H01L 21/762, H01L 21/265

(54) **PROCEDE DE FORMATION D'UNE ZONE FRAGILE DANS UN SUBSTRAT PAR CO-IMPLANTATION**
HERSTELLUNGSVERFAHREN FÜR EINE BRUCHZONE IN EINEM SUBSTRAT DURCH KOIMPLANTATION
METHOD FOR FORMING A BRITTLE ZONE IN A SUBSTRATE BY CO-IMPLANTATION

(30) Priorité: 07.11.2002 FR 0213934
(43) Date de publication de la demande: 03.08.2005
(73) Titulaire: COMMISSARIAT A L'ENERGIE ATOMIQUE, 75015 Paris (FR)
(72) Inventeur: ASPAR, Bernard, F-38140 Rives (FR); LAGAHE, Christelle, F-38134 Saint Joseph de Rivière (FR); SOUSBIE, Nicolas, 38000 Grenoble (FR); MICHAUD, Jean-François, F-73800 Saint Pierre de Soucy (FR)
(74) Mandataire: Bonnans, Arnaud
(86) Numéro de dépôt international: PCT/FR2003/003256
(87) Numéro de publication internationale: WO 2004/044976

(56) Documents cités:
- EP-A- 0 786 801
- EP-A- 0 801 419
- WO-A-00/63965
- FR-A- 2 773 261
- FR-A- 2 774 510
- US-A- 6 150 239
- PATENT ABSTRACTS OF JAPAN vol. 1999, no. 08, 30 juin 1999 (1999-06-30) -& JP 11 087668 A (MITSUBISHI MATERIALS SHILICON CORP), 30 mars 1999 (1999-03-30)
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 mars 1998 (1998-03-02), pages 1086-1088, XP000742819 ISSN: 0003-6951 cité dans la demande

## Description

L'invention concerne la séparation d'une couche mince à la surface d'un substrat « source », dans le but, habituellement, de reporter cette couche mince sur un substrat « cible ».

Par couche mince, on entend, de façon classique, une couche dont l'épaisseur est habituellement comprise entre quelques dizaines d'angström et plusieurs micromètres.

Il existe de nombreux exemples d'applications où les techniques de report de couche peuvent représenter une solution au problème de l'intégration de couches sur un support a priori inadapté à leur réalisation. Le transfert d'une couche mince sur un autre support fournit en effet aux ingénieurs un degré de liberté précieux pour pouvoir concevoir des structures impossibles par ailleurs.

Ces prélèvements de films minces permettent par exemple de réaliser des structures dites «enterrées» telles que des condensateurs enterrés pour les « DRAM » (initiales des mots anglais *« Dynamic Random Access Memory* », c'est-à-dire « Mémoire Vive Dynamique »), où les condensateurs sont construits puis reportés sur un autre substrat de silicium ; on reprend ensuite la fabrication du reste des circuits sur ce nouveau substrat.

On rencontre un autre exemple encore dans le domaine des applications liées aux télécommunications et hyperfréquence. Dans ce cas, on préfère que les microcomposants soient intégrés au stade final sur un support présentant une résistivité élevée, typiquement de plusieurs kohm·cm au moins. Mais on ne trouve pas aisément un substrat fortement résistif aux mêmes coût et qualité que les substrats standard habituellement utilisés. Une solution consiste à réaliser les microcomposants sur des substrats standards, puis à reporter, lors des étapes finales, une couche fine contenant les microcomposants sur un substrat isolant tel que le verre, le quartz ou le saphir.

D'un point de vue technique, ces opérations de transfert ont pour intérêt majeur de décorréler les propriétés de la couche dans laquelle sont formés les microcomposants de celles de la couche servant de support final, et sont par conséquent intéressantes dans bien d'autres cas encore.

On peut encore citer les cas où le substrat d'intérêt pour la réalisation des microcomposants coûte excessivement cher. Dans ce cas, par exemple celui du carbure de silicium qui offre de meilleures performances (températures d'utilisation plus élevées, puissances et fréquences maximum d'utilisation significativement améliorées, et ainsi de suite) mais dont le coût est très élevé comparativement au silicium, on aurait intérêt à transférer une couche fine du substrat cher (ici, le carbure de silicium) sur le substrat bon marché (ici, le silicium), et à récupérer le résidu du substrat cher pour réutilisation, après éventuellement une opération de recyclage. L'opération de transfert peut avoir lieu avant, au cours, ou après la réalisation des microcomposants.

Ces techniques peuvent également trouver leur intérêt dans tous les domaines où obtenir un substrat mince est important pour l'application finale. En particulier, on peut citer les applications de puissance, pour des raisons liées à l'évacuation de chaleur (qui sera d'autant meilleure que le substrat est fin) ou au fait que le courant électrique doit parfois traverser l'épaisseur des substrats, avec des pertes qui sont en première approximation proportionnelles à l'épaisseur traversée par ce courant. On peut aussi citer les applications de cartes à puce, dans lesquelles une finesse des substrats est recherchée pour des raisons de souplesse. De même, on peut citer les applications destinées à la réalisation de circuits tridimensionnels ainsi que d'empilements de structures.

Pour nombre d'applications, les étapes préliminaires sont réalisées sur des substrats épais ou d'épaisseur standard, avec pour avantages, d'une part, de bien supporter mécaniquement les différentes étapes technologiques, et d'autre part de répondre aux normes concernant leur passage sur certains équipements de production. Il est donc nécessaire de réaliser un amincissement pour conduire à l'application finale.

Pour réaliser le transfert d'une couche mince issue d'un substrat source vers un substrat cible, certains procédés connus sont fondés sur la création dans un matériau d'une couche fragile enterrée, par implantation d'une ou plusieurs espèces gazeuses.

La demande de brevet FR-2 681 472 divulgue un tel procédé. Les espèces implantées créent une zone enterrée fragilisée par la présence de défauts tels que des micro-cavités, en particulier des micro-bulles (de forme essentiellement sphérique, en anglais *« bubbles* ») ou des « platelets » (en forme de lentille, en anglais « *platelets* »). Cette zone enterrée délimite avec la surface du substrat source une couche mince qui sera par la suite reportée sur le substrat cible.

Pour des variantes concernant la création d'une couche fragile enterrée par implantation d'une ou plusieurs espèces gazeuses, on pourra également se référer aux documents US-5,374,564 (ou EP-A-533551), US-6,020,252 (ou EP-A-807970), FR-2 767 416 (ou EP-A-1010198), FR-2 748 850 (ou EP-A-902843), FR-2 748 851, et FR-2 773 261 (ou EP-A-963598).

La taille caractéristique des défauts crées par une implantation ionique va du nanomètre à quelques dizaines de nanomètres. Le substrat ainsi fragilisé peut le cas échéant subir des traitements thermiques : on veillera alors à ce qu'un recuit thermique n'induise pas de déformation ou d'exfoliation de surface. Le substrat fragilisé peut aussi subir des étapes de dépôt, d'oxydation thermique, d'épitaxie en phase gazeuse ou liquide, ou des traitements d'élaboration de microcomposants électroniques et/ou optiques et/ou de capteurs.

Si les doses d'implantation ont été bien choisies, un apport subséquent d'énergie, par exemple un traitement thermique, au niveau de la zone enterrée fragilisée va favoriser la croissance des micro-cavités, de façon à former des micro-fissures. La couche enterrée d'inclusions est utilisée comme couche de piégeage dans le substrat. Celle-ci permet de localiser, préférentiellement au niveau de cette couche de piégeage, et en quantité suffisante, des espèces gazeuses qui pourront contribuer à la séparation finale de la couche mince superficielle délimitée par la zone d'inclusions et la surface du substrat source.

Cette étape de séparation peut être effectuée à l'aide de traitements thermiques et/ou mécaniques adéquats.

L'avantage de tels procédés à couche fragile enterrée est de pouvoir réaliser des couches à base de matériaux cristallins (Si, SiC, InP, AsGa, LiNbO₃, LiTaO₃, et ainsi de suite) dans une gamme d'épaisseurs pouvant aller de quelques dizaines d'angström à plusieurs micromètres, avec une très bonne homogénéité. Des épaisseurs plus élevées sont également accessibles.

Ces méthodes permettent en particulier la réutilisation du substrat après séparation, ces substrats ne se consommant que très peu à chaque cycle. En effet, les épaisseurs de substrat sont quant à elles habituellement de plusieurs centaines de microns. On travaille ainsi avec des substrats que l'on peut qualifier de substrats « recyclables ».

Les espèces gazeuses implantées dans le substrat source peuvent être par exemple des ions d'hydrogène et/ou de gaz rares.

L'article intitulé «Efficient production of silicon-on-insulator films by co-implantation of He+ with H+ » par Agarwal et al. (Appl. Phys. Lett., vol. 72, n° 9, mars 1998) décrit un procédé comprenant la co-implantation de deux espèces chimiques, à savoir l'hydrogène et l'hélium, dans un substrat de silicium. Les auteurs spécifient que les profils d'implantation des deux espèces implantées doivent être localisés à la même profondeur. Il est ainsi possible de diminuer la dose totale implantée permettant l'obtention ultérieure de la fracture, par rapport à l'utilisation de l'une ou l'autre espèce chimique seule : selon les auteurs, cette technique permet une diminution de la dose totale implantée de l'ordre de 50%. Les auteurs divulguent également que l'ordre d'implantation des deux espèces implantées est important : l'hydrogène doit être implanté en premier, et l'hélium en second ; si l'hélium était implanté en premier, la diminution de la dose totale implantée serait selon eux moins importante.

Lorsque l'on fait pénétrer des atomes dans le substrat source, par exemple par implantation ionique, ces atomes se distribuent selon un profil quasi-gaussien comportant un pic, avec un maximum de concentration à une certaine profondeur qui croît avec l'énergie d'implantation des atomes. A partir d'une concentration que l'on appellera « critique », les atomes implantés engendrent dans le matériau, comme expliqué ci-dessus, des défauts sous la forme, par exemple, de micro-bulles et/ou de platelets et/ou de micro-cavités et/ou de boucles de dislocation et/ou d'autres défauts cristallins, qui amoindrissent la qualité cristalline du matériau. Cette concentration critique dépend, de façon importante, de l'espèce implantée, ainsi que de la nature du substrat source implanté.

La fracture subséquente du substrat se produira aux profondeurs pour lesquelles la densité de défauts cristallins est suffisamment importante, ce qui requiert que la concentration implantée dépasse suffisamment la concentration critique. La profondeur du pic d'implantation étant fonction de l'énergie d'implantation ionique, cette énergie détermine en définitive l'épaisseur de la couche mince à reporter.

Après fracture, la couche mince reportée comporte une couche perturbée en surface : par couche perturbée, on comprendra, dans le cadre de la présente invention, une couche comportant des vestiges, sous forme de rugosités et de défauts cristallins, des effets destructeurs de l'implantation ionique. L'épaisseur de cette couche perturbée augmente avec l'énergie d'implantation et avec la concentration en ions implantés.

Pour restituer une excellente qualité à la couche mince reportée, il faut supprimer cette couche perturbée. Les techniques permettant cette suppression sont nombreuses : on peut à titre d'exemple citer le polissage mécano-chimique, l'oxydation sacrificielle, ou l'attaque chimique (humide ou sèche). Notons que plus l'épaisseur retirée est importante, et plus l'homogénéité en épaisseur de la couche mince reportée risque d'être dégradée. La réduction de l'épaisseur de la couche perturbée permet de limiter les traitements cités ci-dessus et présente donc, notamment, l'avantage de favoriser l'homogénéité en épaisseur de la couche mince reportée. Pour certaines applications, la réduction des coûts de traitement des substrats après report est également un atout majeur.

La demande de brevet WO 99/39378 divulgue un procédé permettant de diminuer l'épaisseur de la couche perturbée présente à la surface de la couche mince reportée, après l'étape de fracture. Ce document propose de réaliser des implantations multiples dans le substrat source. Les étapes consistent à :
- implanter des atomes dans le substrat source à une première profondeur pour obtenir une première concentration d'atomes à cette première profondeur,
- implanter des atomes dans ce même substrat à une deuxième profondeur, différente de la première, pour obtenir à cette deuxième profondeur, une deuxième concentration d'atomes, inférieure à la première,
- effectuer sur ce substrat un traitement apte à faire migrer vers la première profondeur au moins une partie des atomes implantés à la deuxième profondeur, de manière à engendrer préférentiellement des micro-cavités à la première profondeur.

Le principe général de cette invention décrit une séquence de deux ou plusieurs implantations, à deux ou plusieurs profondeurs différentes. On utilisera par la suite l'expression « pic principal » pour désigner le pic d'espèces implantées au niveau duquel on souhaite opérer la fracture ultérieurement, et l'expression « pic secondaire » pour les autres espèces implantées.

Un inconvénient de ce procédé est que les concentrations d'ions implantés au niveau du ou des pic(s) secondaire(s) (qui forment les réservoirs d'atomes pour le premier pic) sont maintenues inférieures à la concentration au niveau du pic principal. Ainsi, si l'on veut réduire substantiellement la concentration d'ions implantés à ladite première profondeur (pour diminuer l'épaisseur de la zone perturbée après fracture), il devient nécessaire de réaliser un grand nombre d'implantations successives, de façon à introduire dans le substrat source la quantité nécessaire d'atomes permettant l'obtention ultérieure de la fracture au niveau du premier pic. Réaliser un grand nombre d'implantations revient à augmenter le coût du procédé et rend particulièrement complexe l'enchaînement des étapes.

Afin de remédier à cet inconvénient, l'invention propose, selon un premier aspect, un procédé de fabrication d'une couche mince, dans lequel on crée une zone fragile enterrée par implantation d'une espèce chimique dans un substrat, de manière à pouvoir ensuite déclencher une fracture dudit substrat le long de cette zone fragile afin d'en détacher ladite couche mince, ledit procédé étant remarquable en ce qu'il comprend les étapes suivantes :
a) une implantation « principale » dans le substrat à une profondeur « principale » d'une espèce chimique « principale », et
b) au moins une implantation « secondaire » dans le substrat, à une profondeur « secondaire » différente de ladite profondeur principale, et à une concentration supérieure à la concentration de l'espèce principale, d'au moins une espèce chimique « secondaire » d'efficacité moindre que l'espèce principale à fragiliser le substrat,
   où lesdites étapes a) et b) peuvent êtres mises en oeuvre dans un ordre quelconque, et en ce qu'il comprend en outre les étapes suivantes :
c) la migration d'au moins une partie de ladite espèce secondaire jusqu'au voisinage de la profondeur principale, et
d) le déclenchement de ladite fracture, le long de la profondeur principale.

Ainsi, selon l'invention, on implante au moins deux espèces différentes, caractérisées par leur efficacité différente à former une zone fragilisée dans le substrat source. Par fragilisation, on entend la formation de défauts spécifiques de type micro-bulles et/ou micro-cavités et/ou platelets et/ou autres défauts cristallins dont la forme, la taille et la densité seront propices à la propagation future d'une fracture dans cette zone. L'efficacité d'une espèce chimique donnée à former une zone fragilisée dépend de façon importante du matériau constituant le substrat. Par exemple, l'espèce chimique principale implantée pourra être constituée d'ions d'hydrogène, la ou les espèces chimiques secondaires pourront être constituées d'ions d'au moins un gaz rare, et le substrat pourra être en silicium, sans que cette combinaison d'éléments soit limitative.

L'un des profils implantés localise la fracture qui sera provoquée ultérieurement et qui permettra le report d'une couche mince superficielle ; l'autre correspond à un réservoir d'espèces qui, après migration, faciliteront la propagation de la fracture. Deux implantations sont habituellement suffisantes.

On notera que la concentration secondaire en espèce de moindre efficacité peut être égale à une fraction importante de la concentration qui serait suffisante pour que l'on puisse ultérieurement provoquer la fracture du substrat au niveau de cette implantation secondaire (il faudra naturellement conserver, en choisissant cette concentration secondaire, une certaine marge de sécurité pour éviter que le substrat ne se fracture à ce niveau). Or comme l'espèce secondaire possède, selon l'invention, une efficacité moindre que l'espèce principale, cela signifie en pratique que la concentration secondaire peut être nettement supérieure à la concentration principale.

Grâce à la présente invention, on obtient donc, au moyen d'un nombre faible d'implantations, une zone fragilisée apte à servir ultérieurement de ligne de fracture, dans laquelle, en outre, la couche perturbée est relativement mince.

Sans prétendre vouloir fournir une explication physique définitive, on pourra attribuer ces avantages de l'invention au mécanisme suivant. En examinant ce mécanisme, on gardera à l'esprit qu'après implantation, les ions implantés peuvent le cas échéant former des atomes neutres, ou se lier au substrat.

Il est probable que « l'efficacité » d'une espèce, c'est-à-dire sa capacité à fragiliser le substrat, va de pair avec le piégeage, mentionné ci-dessus, de l'espèce implantée dans les défauts engendrés par l'implantation. Par exemple, dans le cas de l'implantation d'ions H⁺ dans le silicium, il est connu que ces deux effets résultent probablement de la capacité de cette espèce à former des liaisons chimiques avec le substrat. Ainsi, lors de l'étape c), la tendance à s'éloigner par diffusion de son pic d'implantation est plus forte pour l'espèce secondaire que pour l'espèce principale, précisément en raison de la moindre efficacité de l'espèce secondaire par comparaison avec l'espèce principale. L'espèce secondaire vient alors se loger, sous forme de gaz libre concentré, dans les micro-cavités préalablement crées par l'implantation principale, et favorise la croissance de ces micro-cavités, sans pour autant élargir la zone perturbée au niveau du pic principal.

Selon des caractéristiques particulières, ladite profondeur secondaire est supérieure à ladite profondeur principale. Dans ce cas, les éventuels défauts cristallins engendrés par l'implantation secondaire seront situés en-dehors de la couche mince obtenue par le procédé selon l'invention. Cette disposition contribue donc à l'obtention d'une couche mince de haute qualité.

Selon d'autres caractéristiques particulières, la profondeur secondaire est, au contraire, inférieure à la profondeur principale. En effet, une telle disposition peut être avantageuse pour certaines applications, par exemple lorsqu'on souhaite former au moyen de l'implantation secondaire une couche de défauts cristallins spécifiques localisés au sein de la couche mince ; cette couche de défauts pourra par exemple présenter des propriétés d'isolation électrique et/ou de piégeage.

Selon des caractéristiques particulières, ladite étape c) de migration est favorisée par un traitement thermique approprié. Cette caractéristique permet d'augmenter considérablement l'efficacité du procédé selon l'invention, et aussi de réduire sa durée de mise en oeuvre. En effet, un tel traitement thermique joue un double rôle : d'une part, il favorise le développement des défauts cristallins présents au niveau du pic principal, et d'autre part il favorise simultanément la migration des espèces secondaires (ions ou atomes).

Selon d'autres caractéristiques particulières, ladite étape d) est réalisée à l'aide d'un traitement thermique approprié. Sous l'effet de ce traitement thermique, le gaz d'espèces secondaires crée, au niveau du pic d'implantation principal, un effet de pression important qui contribue à la fracture du substrat source.

Les caractéristiques des traitements thermiques appliqués seront choisies judicieusement en fonction de l'application concernée. Par exemple, pour certaines applications, il peut être utile - et il est possible grâce à l'invention - d'opérer avec un budget thermique inférieur à celui qui serait nécessaire pour déclencher ladite fracture en l'absence des étapes b) et c), c'est-à-dire selon l'art antérieur (par « budget thermique », on entend l'application d'une température donnée pendant un temps donné). Selon un autre point de vue, compte tenu d'un budget thermique prédéterminé (requis par une application particulière de l'invention), on veillera à respecter ce budget thermique, au besoin en réalisant une implantation d'espèces secondaires supérieure à celle qui serait nécessaire pour pouvoir déclencher ladite fracture avec un budget thermique supérieur audit budget thermique prédéterminé.

Selon un second aspect, l'invention concerne une couche mince obtenue à l'aide de l'un des procédés décrits succinctement ci-dessus, avant ou après son report sur un support final.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1 est un graphique montrant les profils de concentration d'ions ou d'atomes hydrogène implantés dans un substrat en fonction de la profondeur dans le substrat, pour trois doses d'implantation données en exemple,
- la figure 2 est un graphique montrant l'épaisseur de la zone perturbée en fonction de la dose d'implantation dans le cas d'une implantation d'ions H⁺ dans le silicium,
- les figures 3a à 3d représentent les étapes successives principales du procédé selon l'invention, et
- la figure 4 est un graphique montrant les profils de concentration, en fonction de la profondeur dans le substrat, de l'espèce principale et de l'espèce secondaire implantées au cours des étapes illustrées sur les figures 3a et 3b.

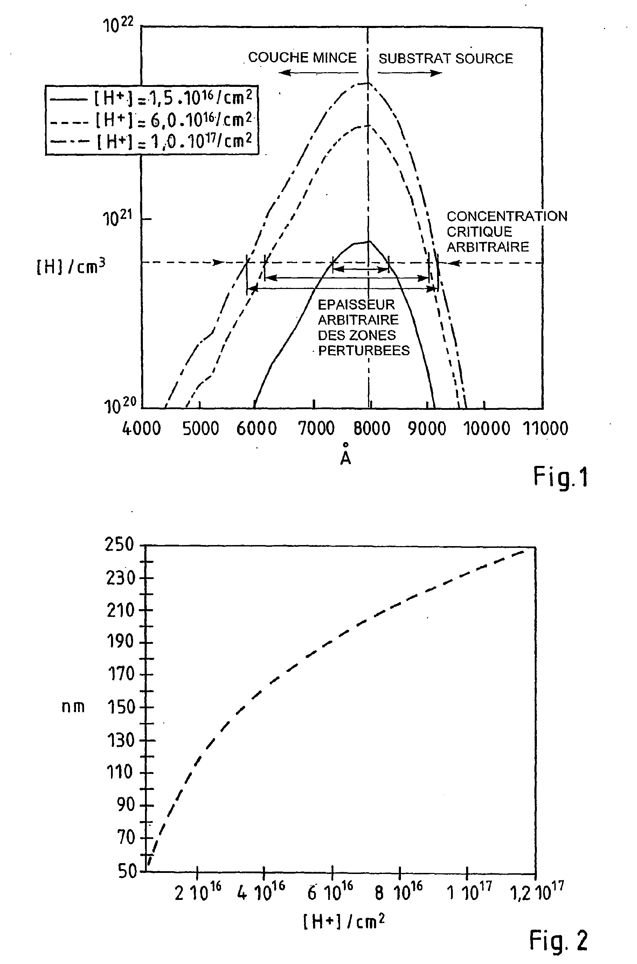

La **figure 1** montre, à titre d'exemple, trois profils d'implantation d'ions H⁺ dans un substrat en silicium. Ces profils montrent, pour des doses d'implantation ionique égales à 1,5·10¹⁶ H⁺/cm², 6,0·10¹⁶ H⁺/cm², et 1,0·10¹⁷ H⁺/cm², à une énergie de 75 keV environ, la concentration obtenue (en nombre d'ions ou d'atomes d'hydrogène par cm³) dans ce substrat, en fonction de la profondeur au-dessous de la surface implantée du substrat. La figure indique, purement à titre indicatif, le niveau minimum de concentration (concentration critique) qui conduit à l'apparition de défauts cristallins causés par l'implantation ionique.

Ici, les trois courbes de concentration s'élèvent au-dessus de cette concentration critique, de sorte que, pour chaque courbe de concentration, on en déduit l'existence d'une zone perturbée dans le substrat (zone comportant des défauts cristallins ayant pour origine l'implantation ionique) située essentiellement entre les deux niveaux de profondeur où ladite courbe croise la ligne de concentration critique.

On peut associer ainsi à chaque implantation de dose suffisamment élevée, une épaisseur correspondante de zone perturbée, qui n'est montrée sur la figure 1 qu'à titre indicatif. La figure 2 présente des données expérimentales concernant cette épaisseur, pour une gamme de doses implantées allant de 0,5·10¹⁶ H⁺/cm² à 1,2·10¹⁷ H⁺/cm², à une énergie de 75 keV environ. On constate que la largeur de la zone perturbée croît avec la dose implantée, ici entre 50 et 250 nanomètres (nm) environ. Après fracture, l'épaisseur de la couche perturbée mise en évidence à la surface de la couche mince reportée sera approximativement comprise entre 1/3 et 2/3 de l'épaisseur de la zone perturbée avant fracture.

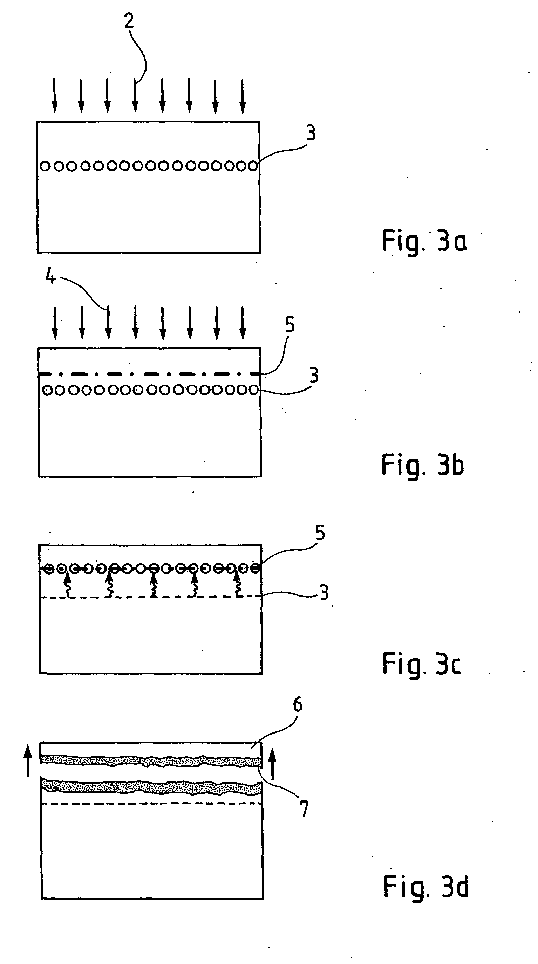

Les figures 3a à 3d illustrent les étapes principales successives d'un procédé selon un mode de réalisation de l'invention.

La **figure 3a** montre l'implantation d'un substrat source 1 par une espèce chimique « secondaire » 2, qui crée une concentration de cette espèce secondaire 2 au sein du substrat 1 autour d'un pic de profondeur « secondaire » 3.

La **figure 3b** montre l'implantation par une espèce chimique «principale» 4 au droit de la même partie du substrat 1, qui crée une concentration de cette espèce principale 4 au sein du substrat 1 autour d'un pic de profondeur « principale » 5.

Au niveau de ce pic principal 5, le procédé selon l'invention enseigne d'implanter une espèce 4 montrant une efficacité importante pour fragiliser le substrat source. On implante au niveau du pic secondaire 3 des espèces 2 moins efficaces pour former des défauts de fragilisation.

Le mode de réalisation illustré ici concerne une application dans laquelle il importe d'optimiser la qualité de la couche mince obtenue en fin de processus. C'est pourquoi l'implantation de l'espèce secondaire 2, qui sert à constituer un réservoir d'atomes, est ici réalisée à une profondeur 3 supérieure à la profondeur d'implantation 5 de l'espèce principale 4 où la fracture du substrat 1 aura lieu ultérieurement.

La **figure 3c** illustre l'étape suivante de ce mode de réalisation de l'invention. Au cours de cette étape, on applique de préférence un traitement thermique (four, et/ou chauffage local, et/ou faisceau laser, ou autre), comme expliqué en introduction. Une fraction importante de ces espèces vient alors alimenter les défauts cristallins présents au niveau du pic principal (5) et favoriser la croissance de ces défauts.

Enfin, la **figure 3d** illustre l'opération classique de fracture du substrat 1 au niveau de la profondeur principale 5, de manière à détacher du substrat source 1 une couche mince 6, que l'on pourra le cas échéant reporter sur un substrat cible (non représenté). Ce détachement fait apparaître une fine couche perturbée 7 à la surface de la couche mince 6 (ainsi qu'une autre couche perturbée à la surface du substrat source 1).

Pour le déclenchement de la fracture, on pourra optionnellement, de façon connue, appliquer un traitement thermique (four, et/ou chauffage local, et/ou faisceau laser, ou autre), et/ou l'application de contraintes mécaniques telles que la projection d'un jet de fluide (gaz, liquide) et/ou l'insertion d'une lame au niveau de la zone fragilisée, et/ou des contraintes en traction, cisaillement ou flexion appliquées au substrat, et/ou des ondes acoustiques (ultrasons, ou autre).

Dans le cas où l'on a choisi de faire usage d'un traitement thermique au cours de l'étape c) de migration, il est avantageux, pour des raisons de simplicité de mise en oeuvre, d'utiliser le même traitement thermique pour l'étape d). On pourra alors commodément réaliser les deux étapes c) et d) sans interruption.

Selon une variante, on appliquera d'abord, de façon connue, une couche d'épaississeur tel que de l'oxyde, du nitrure ou autre ; la présence de ce support permettra de rigidifier la couche transférée du substrat fragilisé, notamment pour des étapes de transport et/ou de finition ; la propagation de la fracture au niveau du pic principal permettra ainsi d'obtenir une couche autoportée comportant la couche mince issue du substrat source et la couche d'épaississeur.

Selon une autre variante, un collage entre le substrat source implanté et un substrat cible pourra être effectué. Le substrat cible peut être, par exemple, en silicium, en plastique, ou en verre, et il peut être souple ou rigide. Cette solidarisation pourra par exemple être effectuée par collage direct (adhésion moléculaire), ou encore par l'utilisation de colles ou autres substances adhésives ; la fracture macroscopique le long de la zone fragilisée donnera alors lieu à la séparation de la structure collée constituée des deux substrats source et cible en deux parties : la première partie constituée de la couche mince superficielle issue du substrat source, reportée sur le substrat cible, la deuxième partie constituée du substrat source pelé d'une couche mince superficielle.

Selon encore une autre variante, avant ou au cours de l'étape d), on applique sur le substrat 1 un support « poignée », le report de la couche mince 6 étant ensuite effectué sur un support final.

Après séparation et report de la couche mince superficielle, le reste du substrat fragilisé peut être recyclé aussi bien en tant que substrat source qu'en tant, le cas échéant, que substrat cible.

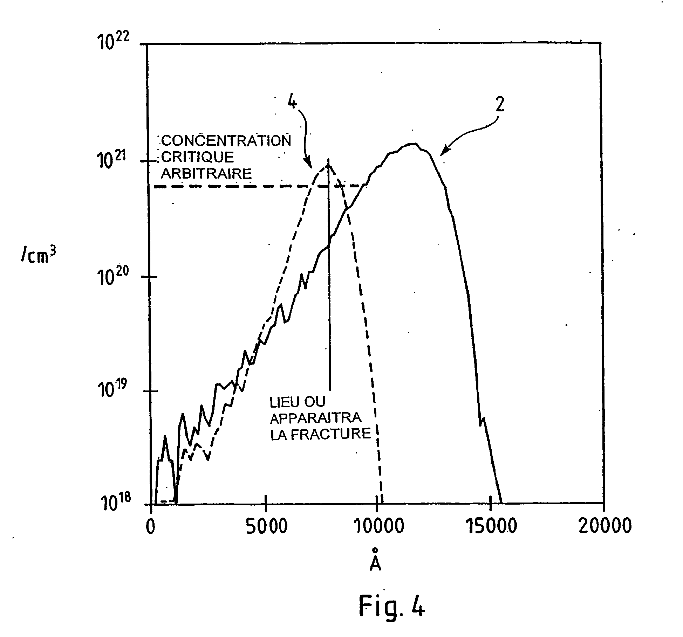

L'avantage du procédé selon l'invention par rapport à la technique décrite dans le document WO 99/39378 est que, du fait des propriétés différentes des deux espèces implantées au niveau des pics principal et secondaire, la dose implantée au niveau du pic principal peut être énormément diminuée par rapport à la dose habituelle nécessaire dans le cas d'une implantation unique (par exemple, dans le cas d'une implantation unique d'ions hydrogène dans le silicium, cette dose habituelle est comprise entre 5·10¹⁶ et 10¹⁷ H⁺/cm²). Cette diminution de la dose d'espèce principale peut, selon les mesures effectuées par les présents inventeurs, atteindre 80%. Parallèlement, la concentration des espèces 2 implantées au niveau du pic secondaire 3 peut nettement dépasser la concentration des espèces 4 implantées au niveau du pic principal 5, comme le montre la figure 4. Le pic secondaire 3 sert ainsi de réservoir d'espèces secondaires 2 destinées à migrer vers le pic principal 5.

La présente invention est notamment adaptée aux applications exigeant un faible budget thermique. Par exemple, lorsque l'on veut reporter par collage une couche mince d'un matériau A sur un substrat de matériau B, et que les propriétés mécaniques (telles que par exemple le coefficient de dilatation thermique) de ces deux matériaux sont différentes, les traitements thermiques appliqués ne peuvent excéder un certain budget thermique au-delà duquel la structure collée constituée des deux substrats de matériau A et B peut subir des dommages (tels qu'une cassure et/ou un décollement).

Pour de telles applications, on peut mettre en oeuvre le procédé selon l'invention en choisissant les doses implantées des deux espèces de manière, à la fois, à déclencher une fracture à basse température à une profondeur prédéterminée, et à imposer une épaisseur prédéterminée de la zone perturbée. La dose d'espèces secondaires 2 sera alors augmentée par rapport à la dose secondaire selon l'invention, afin de favoriser la cinétique de fracture ; de plus, la dose des espèces 4 implantées au niveau du pic principal pourra être comprise entre la dose selon l'invention et la dose habituelle nécessaire pour localiser la fracture. Grâce à ces dispositions, on pourra obtenir, en un temps raisonnable, une fracture à basse température, tout en conservant les avantages provenant du fait que la zone perturbée après fracture est de faible épaisseur.

On va donner ci-dessous, pour terminer, trois exemples numériques de mise en oeuvre de l'invention.

Selon un premier exemple, un substrat de silicium (Si) comportant une couche de silice (SiO₂) thermique en surface (épaisse par exemple de 50 nm) est implanté avec des atomes de néon à raison de 2·10¹⁶ Ne/cm² à une énergie de 210 keV, puis implanté avec de l'hydrogène à raison de 7·10¹⁵ H⁺/cm² à une énergie de 20 keV. Ce substrat source est ensuite solidarisé sur un substrat cible de Si par collage direct. Un traitement thermique à 500°C induit alors la croissance de micro-cavités et/ou de platelets localisés au niveau du pic d'hydrogène : les atomes de néon migrent jusqu'au pic d'hydrogène et participent à la croissance défauts cristallins qui mèneront à la fracture finale. Grâce à l'invention, la largeur de la zone perturbée n'est que de 70 nm environ, alors que dans le cas d'une implantation unique selon l'art antérieur (de l'ordre de 5·10¹⁶ H⁺/cm²), la largeur de la zone perturbée est de 150 nm environ.

Selon un deuxième exemple, un substrat de germanium (Ge) sur lequel on a déposé une couche de SiO₂ (épaisse, par exemple, de 100 nm) est implanté avec des atomes d'hélium à raison de 4·10¹⁶ He/cm² à une énergie de 180 keV, puis implanté avec de l'hydrogène à raison de 2·10¹⁶ H⁺/cm² à une énergie de 60 keV. Ce substrat source peut ensuite être solidarisé sur un substrat cible de Si par collage direct. Un traitement thermique à 300°C induit ensuite la croissance des micro-cavités et/ou platelets localisés au niveau du pic d'hydrogène, les atomes d'hélium diffusant jusqu'à cette zone de défauts cristallins et participant à la mise sous pression et au développement de ceux-ci. La fracture finale au niveau du profil d'hydrogène mène au report de la couche de Ge sur le substrat de Si. Grâce à l'invention, la largeur de la zone perturbée n'est que de 300 nm environ, alors que dans le cas d'une implantation unique selon l'art antérieur, la largeur de la zone perturbée est de 400 nm environ.

Selon un troisième exemple, un substrat de Si comportant une couche de SiO₂ thermique en surface (épaisse, par exemple, de 200 nm) est implanté avec des atomes d'hélium à raison de 4·10¹⁶ He/cm² à une énergie de 180 keV, puis implanté avec de l'hydrogène à raison de 2·10¹⁶ H⁺/cm² à une énergie de 75 keV. Ce substrat source peut ensuite être solidarisé, par collage direct, sur un substrat cible de silice fondue. La différence qui existe entre les coefficients de dilatation thermique de ces deux matériaux impose de réaliser un traitement thermique de fracture à basse température, habituellement de l'ordre de 300°C. Avec les doses d'implantation unique d'hydrogène utilisées classiquement (de l'ordre de 9·10¹⁶ H⁺/cm²), il faudrait plusieurs jours pour parvenir à déclencher, à cette température, la fracture du substrat de Si le long de la zone fragile. En revanche, dans les conditions de co-implantation mentionnées ci-dessus, le traitement thermique induit la croissance des cavités localisées au niveau du pic d'hydrogène, les atomes d'hélium diffusant jusqu'à la zone de défauts cristallins et participant à la mise sous pression et au développement de ceux-ci, de sorte que la fracture finale au niveau du profil d'hydrogène peut être réalisée en une heure environ seulement. On obtient ainsi efficacement le report de la couche de Si sur le substrat de silice fondue. De plus, grâce à l'invention, la largeur de la zone perturbée n'est que de 110 nm environ, alors que dans le cas de l'implantation unique selon l'art antérieur, la largeur de la zone perturbée est de 230 nm environ.

## Revendications

1. Procédé de fabrication d'une couche mince, dans lequel on crée une zone fragile enterrée par implantation d'une espèce chimique dans un substrat (1), de manière à pouvoir ensuite déclencher une fracture dudit substrat (1) le long de cette zone fragile afin d'en détacher ladite couche mince (6), ledit procédé étant **caractérisé en ce qu'**il comprend les étapes suivantes :
a) une implantation principale dans le substrat (1) à une profondeur principale (5) d'une espèce chimique principale (4), et
b) au moins une implantation secondaire dans le substrat (1) à une profondeur secondaire (3) différente de ladite profondeur principale (5), et à une concentration supérieure à la concentration de l'espèce principale (4), d'au moins une espèce chimique secondaire (2) d'efficacité moindre que l'espèce principale (4) à fragiliser le substrat (1),
où lesdites étapes a) et b) peuvent être mises en oeuvre dans un ordre quelconque, et **en ce qu'**il comprend en outre les étapes suivantes :
c) la migration d'au moins une partie de ladite espèce secondaire (2) jusqu'au voisinage de la profondeur principale (5), et
d) le déclenchement de ladite fracture, le long de la profondeur principale (5).

2. Procédé de fabrication selon la revendication 1, **caractérisé en ce que** ladite profondeur secondaire (3) est supérieure à ladite profondeur principale (5).

3. Procédé de fabrication selon la revendication 1, **caractérisé en ce que** ladite profondeur secondaire (3) est inférieure à ladite profondeur principale (5).

4. Procédé de fabrication selon la revendication 2 ou la revendication 3, **caractérisé en ce que** ladite au moins une implantation secondaire est mise en oeuvre avant ladite implantation principale.

5. Procédé de fabrication selon l'une quelconque des revendications 1 à 4, **caractérisé en ce que** ladite étape c) est favorisée par un traitement thermique approprié.

6. Procédé de fabrication selon l'une quelconque des revendications 1 à 5, **caractérisé en ce que** ladite étape d) est réalisée à l'aide d'un traitement thermique approprié.

7. Procédé de fabrication selon la revendication 5 et la revendication 6, **caractérisé en ce que** les étapes c) et d) sont réalisées au cours d'un même traitement thermique.

8. Procédé de fabrication selon l'une des revendications 5 à 7, **caractérisé en ce que** ledit traitement thermique est effectué avec un budget thermique inférieur à celui qui serait nécessaire pour déclencher ladite fracture en l'absence des étapes b) et c).

9. Procédé de fabrication selon l'une des revendications 5 à 7, **caractérisé en ce que** l'on respecte un budget thermique prédéterminé, au besoin en réalisant une implantation d'espèces secondaires (2) supérieure à celle qui serait nécessaire pour pouvoir déclencher ladite fracture avec un budget thermique supérieur audit budget thermique prédéterminé.

10. Procédé de fabrication selon l'une quelconque des revendications 5 à 9, **caractérisé en ce que** ledit traitement thermique comprend un chauffage au four et/ou un chauffage local et/ou un chauffage au laser.

11. Procédé de fabrication selon l'une quelconque des revendications précédentes, **caractérisé en ce que** ladite étape d) comporte l'application de contraintes mécaniques.

12. Procédé de fabrication selon la revendication 11, **caractérisé en ce que** lesdites contraintes mécaniques comprennent l'utilisation d'un jet de fluide et/ou l'insertion d'une lame au niveau de la zone implantée, et/ou des contraintes en traction, cisaillement ou flexion appliquées au substrat (1), et/ou des ondes acoustiques.

13. Procédé de fabrication selon l'une quelconque des revendications 1 à 12, **caractérisé en ce que,** avant ou au cours de l'étape d), on applique sur le substrat (1) un épaississeur qui servira de support à ladite couche mince (6) après sa séparation du substrat (1).

14. Procédé de fabrication selon l'une quelconque des revendications 1 à 12, **caractérisé en ce que,** avant ou au cours de l'étape d), on applique sur le substrat (1) un support "poignée", le report de la couche mince (6) étant ensuite effectué sur un support final.

15. Procédé de fabrication selon l'une quelconque des revendications précédentes, **caractérisé en ce que** l'espèce chimique principale (4) est constituée d'ions ou d'atomes d'hydrogène.

16. Procédé de fabrication selon l'une quelconque des revendications précédentes, **caractérisé en ce que** la ou les espèces chimiques secondaires (2) sont constituées d'ions ou d'atomes d'au moins un gaz rare.

## Claims

1. A method of fabricating a thin layer, in which a weak buried region is created by implanting a chemical species in a substrate (1) in order thereafter to be able to initiate a fracture of said substrate (1) along said weak region in order to detach said thin layer (6) therefrom, said method being **characterized in that** it includes the following steps:
a) a main implantation of a main chemical species (4) in the substrate (1) at a main depth (5), and
b) at least one secondary implantation of at least one secondary chemical species (2) less effective than the main species (4) at weakening the substrate (1), in the substrate (1) at a secondary depth (3) different from said main depth (5) and at a concentration higher than the concentration of the main species (4),
wherein said steps a) and b) can be executed in any order, and **in that** it further includes the following steps:
c) migration of at least a portion of said secondary species (2) up to the neighborhood of the main depth (5), and
d) initiation of said fracture along the main depth (5).

2. A fabrication method according to claim 1, **characterized in that** said secondary depth (3) is greater than said main depth (5).

3. A fabrication method according to claim 1, **characterized in that** said secondary depth (3) is less than said main depth (5).

4. A fabrication method according to claim 2 or claim 3, **characterized in that** said at least one secondary implantation is carried out before said main implantation.

5. A fabrication method according to any one of claims 1 to 4, **characterized in that** said step c) is encouraged by appropriate heat treatment.

6. A fabrication method according to any one of claims 1 to 5, **characterized in that** said step d) is carried out with the aid of an appropriate heat treatment.

7. A fabrication method according to claim 5 and claim 6, **characterized in that** steps c) and d) are carried out during the same heat treatment.

8. A fabrication method according to any one of claims 5 to 7, **characterized in that** said heat treatment is carried out with a thermal budget lower than that which would be necessary to initiate said fracture in the absence of steps b) and c).

9. A fabrication method according to any one of claims 5 to 7, **characterized in that** a predetermined thermal budget is complied with, if necessary by implanting more of the secondary species (2) than would be necessary to be able to initiate said fracture with a thermal budget higher than said predetermined thermal budget.

10. A fabrication method according to any one of claims 5 to 9, **characterized in that** said heat treatment comprises heating in a furnace and/or local heating and/or laser heating.

11. A fabrication method according to any one of the preceding claims, **characterized in that** said step d) includes the application of mechanical stresses.

12. A fabrication method according to claim 11, **characterized in that** said mechanical stresses comprise the use of a jet of fluid and/or the insertion of a blade into the implanted region and/or the application of traction, shear or bending stresses to the substrate (1) and/or acoustic waves.

13. A fabrication method according to any one of claims 1 to 12, **characterized in that,** before or during step d), a thickener is applied to the substrate (1) to serve as a support for said thin layer (6) after its separation from the substrate (1).

14. A fabrication method according to any one of claims 1 to 12, **characterized in that,** before or during step d), a "handle" support is applied to the substrate (1), after which the thin layer (6) is transferred onto a final support.

15. A fabrication method according to any one of the preceding claims, **characterized in that** the main chemical species (4) is constituted by hydrogen ions or atoms.

16. A fabrication method according to any one of the preceding claims, **characterized in that** the secondary chemical species (2) is or are constituted by ions or atoms of at least one noble gas.

## Patentansprüche

1. Verfahren zur Herstellung einer Dünnschicht, bei dem man eine versenkte fragile Zone durch Implantation einer chemischen Spezies in einem Substrat (1) erzeugt, so dass man dann einen Bruch des Substrats (1) längs dieser fragilen Zone auslösen kann, um davon die Dünnschicht (6) abzulösen, wobei das Verfahren **dadurch gekennzeichnet ist, dass** es die folgenden Schritte umfasst:
a) eine Hauptimplantation einer chemischen Hauptspezies (4) in dem Substrat (1) in einer Haupttiefe (5),
b) mindestens eine Nebenimplantation mindestens einer chemischen Nebenspezies (2), die eine geringere Wirksamkeit der Fragilisierung des Substrats (1) als die Hauptspezies (4) besitzt, in dem Substrat (1) in einer von der Haupttiefe (5) verschiedenen Nebentiefe (3) und in einer Konzentration, die höher als die Konzentration der Hauptspezies (4) ist,
worin die Schritte a) und b) in einer beliebigen Reihenfolge durchgeführt werden können, und dass es außerdem die folgenden Schritte umfasst:
c) das Wandern mindestens eines Teils der Nebenspezies (2) bis in die Nähe der Haupttiefe (5) und
d) die Auslösung des Bruchs längs der Haupttiefe (5).

2. Herstellungsverfahren nach Anspruch 1, **dadurch gekennzeichnet, dass** die Nebentiefe (3) größer als die Haupttiefe (5) ist.

3. Herstellungsverfahren nach Anspruch 1, **dadurch gekennzeichnet, dass** die Nebentiefe (3) kleiner als die Haupttiefe (5) ist.

4. Herstellungsverfahren nach Anspruch 2 oder Anspruch 3, **dadurch gekennzeichnet, dass** die mindestens eine Nebenimplantation vor der Hauptimplantation durchgeführt wird.

5. Herstellungsverfahren nach einem der Ansprüche 1 bis 4, **dadurch gekennzeichnet, dass** der Schritt c) durch eine geeignete Wärmebehandlung begünstigt wird.

6. Herstellungsverfahren nach einem der Ansprüche 1 bis 5, **dadurch gekennzeichnet, dass** der Schritt d) mit Hilfe einer geeigneten Wärmebehandlung vorgenommen wird.

7. Herstellungsverfahren nach Anspruch 5 und Anspruch 6, **dadurch gekennzeichnet, dass** die Schritte c) und d) während ein und derselben Wärmebehandlung durchgeführt werden.

8. Herstellungsverfahren nach einem der Ansprüche 5 bis 7, **dadurch gekennzeichnet, dass** die Wärmebehandlung mit einem Wärmebudget durchgeführt wird, das kleiner als dasjenige ist, das zum Auslösen des Bruchs bei Fehlen der Schritte b) und c) erforderlich wäre.

9. Herstellungsverfahren nach einem der Ansprüche 5 bis 7, **dadurch gekennzeichnet, dass** man ein vorbestimmtes Wärmebudget einhält, bei Bedarf, indem man eine Implantation von Nebenspezies (2) vornimmt, die größer als diejenige ist, die erforderlich wäre, um den Bruch mit einem Wärmebudget auslösen zu können, das größer als das vorbestimmte Wärmebudget ist.

10. Herstellungsverfahren nach einem der Ansprüche 5 bis 9, **dadurch gekennzeichnet, dass** die Wärmebehandlung eine Erhitzung im Ofen und/ oder eine lokale Erhitzung und / oder eine Erhitzung durch Laser umfasst.

11. Herstellungsverfahren nach einem der vorhergehenden Ansprüche, **dadurch gekennzeichnet, dass** der Schritt d) das Anlegen von mechanischen Beanspruchungen umfasst.

12. Herstellungsverfahren nach Anspruch 11, **dadurch gekennzeichnet, dass** die mechanischen Beanspruchungen die Verwendung eines Fluidstrahls und/oder die Einführung einer Klinge auf Höhe der implantierten Zone und/oder an das Substrat (1) angelegte Zug-, Scher- oder Biegebeanspruchungen und/ oder Schallwellen umfasst.

13. Herstellungsverfahren nach einem der Ansprüche 1 bis 12, **dadurch gekennzeichnet, dass** man vor oder während des Schritts d) auf das Substrat (1) eine Dicke aufbringt, die als Träger für die Dünnschicht (6) nach ihrer Trennung vom Substrat (1) dient.

14. Herstellungsverfahren nach einem der Ansprüche 1 bis 12, **dadurch gekennzeichnet, dass** man vor oder während des Schritts d) auf das Substrat (1) einen "Griff"-Träger aufbringt, wobei der Übertrag der Dünnschicht (6) dann auf einen endgültigen Träger vorgenommen wird.

15. Herstellungsverfahren nach einem der vorhergehenden Ansprüche, **dadurch gekennzeichnet, dass** die chemische Hauptspezies (4) aus Wasserstoffionen oder -atomen besteht.

16. Herstellungsverfahren nach einem der vorhergehenden Ansprüche, **dadurch gekennzeichnet, dass** die chemische Nebenspezies oder die chemischen Nebenspezies (2) aus Ionen oder Atomen mindestens eines Edelgases bestehen.
